# FASCICULE DE BREVET EUROPEEN

(11) **EP 2 750 203 B1**
(45) Date de publication et mention de la délivrance du brevet: **16.09.2015**
(21) Numéro de dépôt: 13199542.5
(22) Date de dépôt: 24.12.2013
(51) Int. Cl.: H01L 31/107

(54) **Structure semiconductrice du type photodiode à avalanche à faible temps de réponse et procédé de fabrication d'une telle photodiode**
Halbleiterstruktur vom Typ Lawinen-Fotodiode mit geringer Ansprechzeit, und Herstellungsverfahren einer solchen Fotodiode
Avalanche-photodiode semiconductor structure with low response time and method for manufacturing such a photodiode

(30) Priorité: 31.12.2012 FR 1262993
(43) Date de publication de la demande: 02.07.2014
(73) Titulaire: Commissariat à l'Énergie Atomique et aux Énergies Alternatives, 75015 Paris (FR)
(72) Inventeur: Rothman, Johan, 38000 GRENOBLE (FR)
(74) Mandataire: Ahner, Philippe

(56) Documents cités:
- EP-A1- 0 001 139
- EP-A1- 1 903 612
- EP-A2- 2 284 895

## Description

### DOMAINE TECHNIQUE

L'invention se rapporte au domaine des dispositifs de mesure et de détection de lumière.

Ces dernières années, l'application des méthodes de fabrication de la micro-électronique à des matériaux semiconducteurs à gap direct, tels que l'arséniure de gallium et le phosphure d'indium, ont permis d'améliorer les performances des structures optoélectroniques.

Ainsi, parmi ces structures optoélectroniques, l'application de ces technologies aux photodiodes à avalanche actuelles a permis de réduire leur courant d'obscurité, en améliorant ainsi leur sensibilité, et leur temps de réponse. Malgré le faible temps de réponse de ces structures, la recherche visant à réduire le temps de réponse des photodiodes à avalanche reste une problématique d'actualité.

L'invention se rapporte donc plus particulièrement à une structure semiconductrice de type photodiode à avalanche à faible temps de réponse et à un procédé de fabrication d'une telle structure.

### ÉTAT DE LA TECHNIQUE ANTÉRIEURE

Les derniers travaux de recherche sur les photodiodes à avalanche à base de tellurure de mercure-cadmium du type CdₓHg₁₋ₓTe, tels que ceux publiés par J. Rothman et al en 2011 dans le Journal of Electronic Materials, n°40, page 1757, ont montré que de telles photodiodes présentent la particularité de posséder, lorsqu'elles sont adaptées pour fonctionner dans la gamme des infrarouges, un gain par ionisation par impact sélectif puisque seuls les électrons sont multipliés.

Une structure présentant une telle caractéristique comporte généralement :
- une première zone semiconductrice adaptée pour absorber un rayonnement électromagnétique par génération de paires électron-trou, la première zone étant formée dans une couche semiconductrice qui s'étend longitudinalement,
- une deuxième zone semiconductrice en contact avec la première zone, la deuxième zone étant adaptée pour autoriser lors du fonctionnement de la structure une multiplication des porteurs générés dans la première zone, la deuxième zone étant aménagée dans une deuxième couche semiconductrice qui s'étend le long de la première couche,
- une troisième zone semiconductrice permettant de collecter les porteurs multipliés dans le deuxième zone.

Dans une telle structure, la première, la deuxième et la troisième zone sont toutes trois formées dans des tellurures de mercure-cadmium du type CdₓHg₁₋ₓTe avec une proportion x en cadmium de chacune des zones semiconductrices qui est adaptée vis-à-vis de la fonction fournie par ladite zone.

De par l'utilisation de zones semiconductrices en tellurure de mercure-cadmium, une telle structure présente, vis-à-vis d'une structure du type photodiode à avalanche classique, des performances améliorées aussi bien en ce qui concerne le rapport signal sur bruit, et donc la sensibilité, qu'en ce qui concerne le temps de réponse d'une telle structure.

Néanmoins, si de telles structures possèdent des caractéristiques améliorées vis-à-vis des structures formées dans un autre matériau, elles présentent l'inconvénient de ne pas autoriser, dans une configuration classique, une variation de la largeur de bande interdite dans la première zone semiconductrice qui pourrait, par exemple, permettre d'améliorer le temps de réponse de la structure.

En effet, selon cette configuration classique, la première zone est d'un premier type de conductivité pour lequel les porteurs majoritaires sont des électrons et sont obtenus au moyen d'éléments dopant tels que l'arsenic. Or pour certains éléments dopants, tels que l'arsenic, lors du recuit d'activation nécessaire pour activer ces éléments dopants et libérer les porteurs, le cadmium et le mercure interdiffusent dans la zone dans laquelle lesdits éléments dopants ont été implantés. Il en résulte qu'une zone formée en tellurure de mercure-cadmium du type CdₓHg₁₋ₓTe comportant de tels éléments dopants, tels que l'arsenic, présente, après le recuit d'activation, une proportion x de cadmium, et donc une largeur de bande interdite, sensiblement homogène. Ainsi, dans une telle structure, la première zone présente inévitablement une proportion x de cadmium sensiblement constante sur l'ensemble de la zone.

### EXPOSÉ DE L'INVENTION

La présente invention vise à remédier à cet inconvénient.

L'invention a donc pour but de fournir une structure du type photodiode à avalanche comportant au moins une première zone réalisée dans en tellurure de mercure-cadmium du type CdₓHg₁₋ₓTe avec une proportion x de cadmium qui est variée sur au moins une dimension et comportant au moins un élément dopant, tel que l'arsenic, fournissant au moins un porteur sans que la présence de ce dernier élément dopant ait significativement influencé la variation de la proportion x de cadmium dans ladite première zone.

A cet effet, l'invention concerne une structure semiconductrice de type photodiode à avalanche destinée à recevoir un rayonnement électromagnétique dans une gamme de longueurs d'onde donnée et comportant :
- une première zone semiconductrice, dite d'absorption, d'un premier type de conductivité présentant une première face longitudinale destinée à recevoir le rayonnement électromagnétique et une seconde face opposée à la première face, ladite première zone étant réalisée en tellurure de mercure-cadmium du type CdₓHg₁₋ₓTe avec une proportion x de cadmium qui est variée,
- au moins une deuxième zone semiconductrice, dite de multiplication, en contact sur une première face avec la seconde face de la première zone, la deuxième zone présentant une concentration en porteurs majoritaires inférieure à celle de la première zone, ladite deuxième zone étant adaptée pour fournir une multiplication de porteurs par ionisation par impact,
- une troisième zone semiconductrice, dite de collecte, en contact avec la deuxième zone, ladite troisième zone étant d'un deuxième type de conductivité opposé au premier type de conductivité et présentant une concentration en porteurs majoritaires supérieure à celle de la deuxième zone,
la première zone comportant un élément dopant fournissant au moins un porteur majoritaire correspondant au premier type de conductivité, dont la concentration est variée alternativement dans une direction sensiblement perpendiculaire à la première face longitudinale entre une concentration dite faible et une concentration dite forte.

L'utilisation d'une première zone comportant une concentration dans l'élément dopant qui est variée alternativement dans une direction sensiblement perpendiculaire à la première face longitudinale permet d'assurer que la diffusion du cadmium dans ladite première zone pendant le recuit d'activation reste faible. En effet, cette diffusion étant directement reliée aux fortes concentrations en l'élément dopant, tel que l'arsenic, les parties de la première zone qui présentent une faible concentration en ledit élément dopant font office de barrière à la diffusion du cadmium. Elles permettent à la structure de présenter une proportion x en cadmium qui est variée le long de la direction sensiblement perpendiculaire à la première face longitudinale malgré l'utilisation d'un élément dopant fournissant un porteur majoritaire du premier type de conductivité, tel que l'arsenic.

On entend ci-dessus et dans le reste de ce document par proportion de cadmium, la proportion x de cadmium dans un tellurure de mercure-cadmium du type CdₓHg₁₋ₓTe avec la valeur x correspondant à la proportion de cadmium par rapport au mercure.

La deuxième zone peut présenter une concentration en porteurs majoritaires au moins inférieure de 10 fois à celle de la première zone.

La troisième zone peut présenter une concentration en porteurs majoritaires au moins 10 fois plus importante que celle de la deuxième zone

La première zone peut comporter une proportion x en cadmium qui est diminuée en direction de la deuxième zone le long d'un axe sensiblement perpendiculaire à la première face longitudinale.

Une telle variation de la proportion x de cadmium dans la première zone permet de créer un champ électrique le long de la première zone adapté pour accélérer la diffusion en direction de la deuxième zone des porteurs générés dans la première zone. Une telle accélération de la diffusion des porteurs dans la première zone permet de diminuer le temps de réponse de la structure par rapport à une structure ne présentant pas une telle variation de la proportion x de cadmium dans la première zone.

La concentration faible en l'élément dopant peut être sensiblement nulle.

Une telle concentration faible permet de limiter les risques de diffusion du cadmium lors du recuit d'activation dans les parties de la première zone comportant la concentration faible en l'élément dopant. Ainsi, la structure peut comporter une variation de la proportion x de cadmium dans la première zone au moins au niveau des parties de cette première zone comportant la concentration faible en l'élément dopant

L'alternance entre la concentration faible et la concentration forte dans la première zone peut être sensiblement périodique.

Chaque période peut comporter une première partie correspondant à la concentration forte et une deuxième partie correspondant à la concentration faible, le rapport dimensionnel entre la première partie et la deuxième partie selon la direction sensiblement perpendiculaire à la première face longitudinale étant au maximum de 10.

Un tel rapport dimensionnel entre la première et la deuxième partie permet d'assurer une faible résistance série. En effet, avec un tel rapport dimensionnel, les porteurs majoritaires fournis par la deuxième partie permettent d'assurer une bonne conduction à la fois dans la deuxième partie et dans la première partie assurant une conduction sur toute l'épaisseur de la première zone.

La première zone peut être en contact avec la deuxième zone par une région sensiblement dépourvue d'élément dopant.

La région de la première zone par laquelle la première zone est en contact avec la deuxième zone peut comporter une proportion x en cadmium qui est variée en direction de la deuxième zone.

L'élément dopant fournissant au moins un porteur majoritaire peut être l'arsenic.

L'élément dopant fournissant au moins un porteur majoritaire peut être l'or Au ou encore l'antimoine Sb.

L'invention concerne également un procédé de fabrication d'une structure comprenant les étapes consistant à :
- fournir une première zone semiconductrice d'un premier type de conductivité présentant une première face longitudinale destinée à recevoir le rayonnement électromagnétique et une seconde face opposée à la première face, ladite première zone étant en un tellurure de mercure-cadmium de type CdₓHg₁₋ₓTe avec une proportion x de cadmium qui est variée, la première zone comportant un élément dopant dont la concentration est variée alternativement dans la direction perpendiculaire à la première face longitudinale entre une concentration dite faible et une concentration dite forte,
- former une deuxième zone semiconductrice en contact avec la seconde face de la première zone, la deuxième zone présentant une concentration en porteurs majoritaires inférieure à celle de la première zone,
- former une troisième zone semiconductrice en contact avec la deuxième zone, ladite troisième zone étant d'un deuxième type de conductivité opposé au premier type de conductivité et présentant une concentration en porteurs majoritaires supérieure à celle de la deuxième zone.

Un tel procédé permet de fournir une structure de type photodiode à avalanche comportant au moins une première zone réalisée en tellurure de mercure-cadmium du type CdₓHg₁₋ₓTe avec une proportion x de cadmium qui est variée sur au moins une dimension.

L'étape de fourniture de la première zone peut comprendre les sous-étapes consistant à :
- fournir un support comportant une surface longitudinale,
- déposer sur la surface longitudinale du support du tellurure de mercure-cadmium du type CdₓHg₁₋ₓTe en variant la proportion x de cadmium, et en y introduisant l'élément dopant avec une concentration qui est variée alternativement dans la direction sensiblement perpendiculaire à la surface longitudinale entre une concentration dite faible et une concentration dite forte.

Lors de la sous étape consistant à déposer en contact avec la surface du support du tellurure de mercure-cadmium, la concentration en l'élément dopant peut être variée sensiblement périodiquement.

L'élément dopant fournissant au moins un porteur majoritaire peut être l'arsenic.

L'élément dopant fournissant au moins un porteur majoritaire peut être l'or Au ou encore l'antimoine Sb.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :
- la figure 1 illustre une vue en coupe d'une structure selon un premier mode réalisation de l'invention,
- la figure 2 illustre un graphique des variations des concentrations en cadmium et en arsenic dans une première zone semiconductrice d'une structure telle qu'illustrée sur la figure 1,
- La figure 3 illustre un graphique des variations des concentrations en cadmium et en arsenic dans la première zone semiconductrice d'une structure telle qu'illustrée sur la figure 1 lors de sa fabrication avant l'étape d'activation de l'arsenic,
- La figure 4 illustre une vue en coupe d'une structure selon un deuxième mode de réalisation de l'invention dans lequel la structure comporte une troisième zone semiconductrice qui s'étend sur la totalité de la largeur de la deuxième zone semiconductrice,
- La figure 5 illustre une vue en coupe d'une structure selon un troisième mode de réalisation de l'invention dans lequel la structure comporte une couche d'adaptation.
- Figure 6 illustre une vue en coupe d'une structure selon un quatrième mode de réalisation de l'invention dans lequel la structure est délimitée latéralement par le dopage de la zone de multiplication de porteurs.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

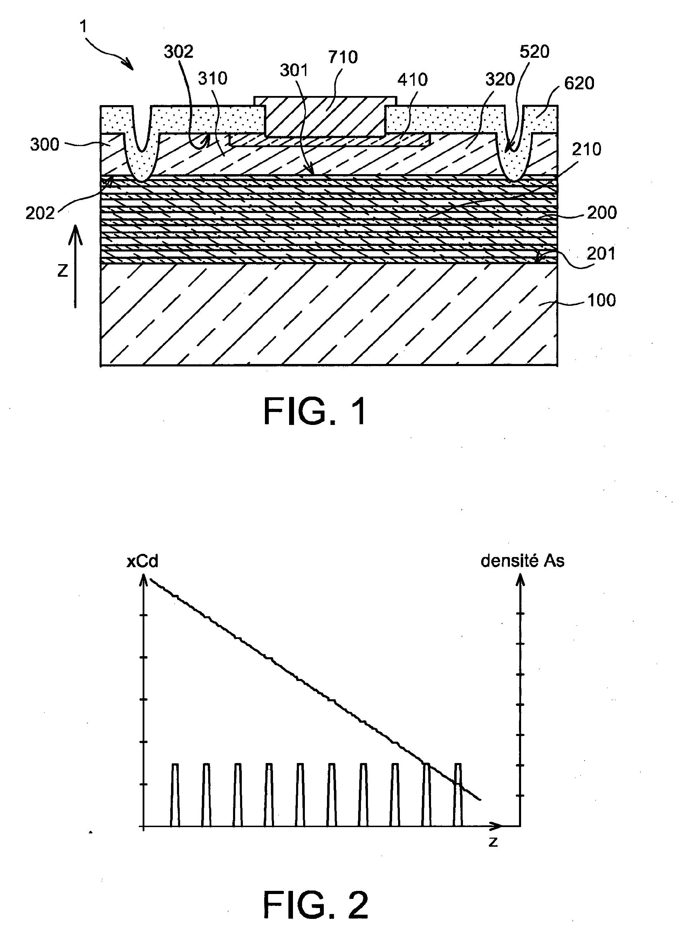

La figure 1 illustre une structure 1 semiconductrice selon un premier mode de réalisation de l'invention, ladite structure 1 étant destinée à la détection et la mesure d'un rayonnement électromagnétique dont la longueur d'onde est comprise dans une gamme de longueurs d'onde donnée.

Afin d'illustrer et de faciliter la compréhension du fonctionnement de la structure selon l'invention, les valeurs et les matériaux qui sont cités ci-dessous, quand cela est précisé, concernent une application particulière de l'invention à la détection et à la mesure de rayonnements électromagnétiques dont la longueur d'onde est comprise dans la gamme de longueurs d'onde du proche infrarouge. Bien entendu, les valeurs et les matériaux concernant cette application ne sont donnés qu'à titre d'illustration et ne sont pas limitatifs.

On entend ci-dessus et dans le reste de ce document par gamme de longueurs d'onde du proche infrarouge une gamme de longueurs d'onde comprise entre 1,5 µm et 5 µm.

Une structure 1 selon le premier mode de réalisation de l'invention comporte :
- un support 100,
- une première zone 210 semiconductrice d'un premier type de conductivité présentant une première face longitudinale 201 destinée à recevoir le rayonnement électromagnétique et une seconde face 202 opposée à la première face 201, ladite première zone 210 comportant une largeur de bande interdite adaptée pour autoriser l'absorption du rayonnement électromagnétique par la première zone dans la gamme voulue,
- une deuxième zone 310 semiconductrice en contact sur une première face 301 avec la seconde face 202 de la première zone 210,
- une troisième zone 410 semiconductrice en contact avec la deuxième zone 310, ladite troisième zone 410 étant d'un deuxième type de conductivité opposé au premier type de conductivité,
- un contact électrique 701 en contact avec la troisième zone 410 et adapté pour polariser la troisième zone 410, le contact électrique formant un premier moyen de polarisation,
- un deuxième moyen de polarisation, non illustré, adapté pour polariser la première zone,
- une couche de passivation 620 en contact avec la deuxième et la troisième zone 310, 410.

Le support 100 est un support adapté pour la formation de la première zone 210 et est au moins partiellement transparent dans la gamme de longueurs d'onde donnée. Ainsi, le support 100 peut être réalisé dans un matériau isolant ou semiconducteur dont la largeur de bande interdite possède une énergie inférieure à l'énergie des photons d'un rayonnement électromagnétique dont la longueur d'onde est comprise dans la gamme de longueurs d'onde donnée.

Le support 100 est réalisé dans un matériau adapté pour supporter une couche en tellurure de mercure-cadmium CdₓHg₁₋ₓTe, tel qu'un tellurure de zinc-cadmium CdₓZn₁₋ₓTe.

Dans l'application particulière, le support 100 est un tellurure de zinc-cadmium CdₓZn₁₋ₓTe avec une proportion de cadmium qui est adaptée pour que le support 100 soit conformé pour la formation de la première couche 200. Ainsi pour, par exemple, une première couche 200 qui est en tellurure de mercure-cadmium CdₓHg₁₋ₓTe avec une proportion x de cadmium de 0,2 au niveau de son contact avec le support 100, le support 100 est un tellurure de zinc-cadmium CdₓZn₁₋ₓTe avec une proportion de cadmium de 0,96.

Le support 100 présente une première et une seconde face, la première face étant la face qui est destinée à recevoir le rayonnement électromagnétique.

La structure 1 comporte en outre une première couche 200 semiconductrice en contact avec le support 100. La première couche 200 s'étend sensiblement longitudinalement le long de la seconde face du support 100. L'épaisseur de la première couche 200 correspond à la direction sensiblement perpendiculaire à la face longitudinale 201 de la première couche 200.

La première couche 200 est réalisée en tellurure de mercure-cadmium CdₓHg₁₋ₓTe avec, sur toute son épaisseur, une largeur de bande interdite qui est adaptée pour autoriser l'absorption des rayonnements électromagnétiques dont la longueur d'onde est comprise dans la gamme de longueurs d'onde donnée. Ainsi, la première couche 200 présente sur toute son épaisseur une proportion x de cadmium adaptée pour que la largeur de bande interdite de la première couche 200 soit inférieure à l'énergie des photons d'un rayonnement électromagnétique dont la longueur d'onde est dans la gamme de longueurs d'onde donnée.

Afin de réduire le temps de réponse de la structure 1, la première couche 200 comporte une proportion x de cadmium qui est variée le long de son épaisseur entre une proportion maximum et une proportion minimum de cadmium. La proportion en cadmium dans la première couche 200 est variée le long de son épaisseur sensiblement monotonement avec, comme cela est illustré sur la figure 2, des zones sur lesquelles la proportion x de cadmium ne varie pas.

Ainsi, dans l'application particulière, la première couche 200 présente une concentration x en cadmium qui est variée entre 0,6 à proximité du support 100 et 0,2 à proximité de la deuxième zone 310, et de préférence à 0,33 à proximité de la deuxième zone 310.

L'épaisseur de la première couche 200 est adaptée pour qu'une majeure partie d'un rayonnement reçu par sur la première face de la structure 1, au niveau de la première zone 210, soit absorbée par la première zone 210.

La partie de la première couche 200, dans laquelle sont générés les paires électron-trou qui sont à l'origine du signal de la structure, forme la première zone 210 de la structure 1.

La première couche 200 présente une épaisseur comprise entre 0,5 et 2 µm.

La première couche 200 est d'un premier type de conductivité pour lequel les porteurs majoritaires sont des électrons.

Les porteurs majoritaires dans la première couche 200 sont fournis au moyen de l'élément dopant qu'est l'arsenic. La concentration en arsenic le long de la première couche 200 est variée alternativement le long de l'épaisseur de la première couche 200 entre une concentration dite faible et une concentration dite forte. L'alternance entre la concentration faible et la concentration forte est sensiblement périodique.

Selon une autre possibilité de l'invention, les porteurs majoritaires de la première couche 200, et donc de la première zone 210, peuvent être fournis au moyen d'un élément dopant autre que l'arsenic, tel que l'or Au ou l'antimoine Sb. La configuration d'une structure selon cette autre possibilité de l'invention est sensiblement identique à celle d'une structure dans laquelle l'élément dopant est l'arsenic. L'utilisation, dans le cadre de l'invention, d'un élément dopant autre que l'arsenic nécessite donc peu d'adaptations qui sont à la portée de l'homme du métier, et est compatible avec l'ensemble des modes de réalisation de l'invention présentés dans ce document. Ainsi, pour ces raisons et afin dee favoriser la clarté et la concision de la description de l'invention, il n'est pas fait mention d'autres éléments dopants que l'arsenic dans le reste de ce document sans que cette absence de mention ne limite la portée de l'invention à l'arsenic comme élément dopant qu'est.

Chaque période comporte une première partie correspondant à la concentration forte et une deuxième partie correspondant à la concentration faible avec un rapport dimensionnel entre la première partie et la deuxième partie selon la direction sensiblement perpendiculaire à la face longitudinale 201 étant au maximum de 10 et typiquement inférieure à 5.

La concentration dite faible est sensiblement nulle pour limiter les risques de diffusion du cadmium le long de l'épaisseur de la première couche 200. Ainsi les parties de la première zone 210 présentant une concentration de type faible sont du type non intentionnellement dopé.

On entend par du « type non intentionnellement dopé » que la concentration en porteurs majoritaires des parties de la première couche 200 qui forment partiellement la première zone 210 est celle d'un matériau dans lequel il n'a pas été intentionnellement introduit d'éléments dopants, c'est-à-dire d'éléments fournissant des porteurs. La valeur et le type de porteurs dans une zone du type non intentionnellement dopé sont liés au procédé de formation de ladite zone.

La concentration en arsenic dite forte est préférentiellement suffisante pour que les porteurs fournis par les parties correspondant à la concentration forte influencent les parties correspondant à la concentration faible. Ainsi, la concentration en arsenic est adaptée pour que la concentration de porteurs majoritaires d'un matériau comportant une telle concentration en arsenic soit supérieure à 20 fois celle de ce même matériau lorsqu'il est du type intrinsèque.

Dans la première couche 200, la concentration en arsenic dite forte, la période et le rapport dimensionnel entre une partie correspondant à la concentration forte et une partie correspondant à la concentration faible selon la direction sensiblement perpendiculaire à la première face longitudinale 201 sont adaptés pour que la concentration en porteurs majoritaires dans la première couche 200 présente une faible résistance série.

Selon une possibilité préférée de l'invention, la première zone 210 est en contact avec la deuxième zone 310 par une région sensiblement dépourvue d'arsenic. Selon cette même possibilité, la région de la première zone 210 par laquelle la première zone 210 est en contact avec la deuxième zone 310 peut comporter une proportion x en cadmium qui est variée en direction de la deuxième zone 310.

Ainsi, dans l'application particulière, la première couche 200 présente une concentration de porteurs majoritaires moyenne comprise entre 10¹⁶ et 4.10¹⁷ cm⁻³.

L'épaisseur de la première couche 200 est adaptée pour qu'une majeure partie d'un rayonnement reçu par la première face de la structure 1 au niveau de la première zone 210 soit absorbée par la première zone 210.

Dans l'application particulière, la première couche 200 est formée dans un tellurure de mercure-cadmium CdₓHg₁₋ₓTe dont la proportion en cadmium x est comprise entre 0,33 et 0,6. Avec une proportion de cadmium de 0,33 et 0,6, la première couche 200 est adaptée pour absorber à une température de 300 K un rayonnement électromagnétique dans une gamme de longueurs d'onde respectivement inférieure à 3.7 µm et à 1.8 µm.

Dans cette même application particulière, le premier type de conductivité est du type de conductivité pour lequel les porteurs majoritaires sont des trous. La concentration en porteurs majoritaires dans la première couche 200 est préférentiellement comprise entre 10¹⁶ et 10¹⁷ cm⁻³. Selon cette application, la première couche 210 présente une épaisseur comprise entre 0,5 et 2 µm.

La partie de la première couche 210 dans laquelle sont générées les paires électron-trou qui sont à l'origine du signal de la structure forme la première zone 210 de la structure 1.

La première couche 200 présente une première et une seconde face 201, 202, la première face 201 étant la face par laquelle la première couche 200 est en contact avec le support 100. La première couche 200 est en contact par sa seconde face 202, qui est opposée à sa première face 201, avec une deuxième couche 300 semiconductrice. La deuxième couche 300 comporte une première face 301 par laquelle elle est en contact avec la seconde face 202 de la première couche 100.

La deuxième couche 300 est une couche semiconductrice dont une portion, qui forme la deuxième zone 310, est adaptée pour, lors du fonctionnement de la structure 1, former une couche multiplicatrice de porteurs. Pour obtenir une telle adaptation, la portion de la deuxième couche 300 semiconductrice qui forme la deuxième zone 310 comporte une concentration en porteurs majoritaires qui est au moins 10 fois inférieure à celle de la première zone 210 et préférentiellement 50 fois inférieure. La deuxième couche 200, en fonction des contraintes de fonctionnement de la structure 1, peut être du premier type de conductivité ou d'un deuxième type de conductivité qui est opposé au premier type de conductivité.

Selon une autre possibilité de l'invention, la portion de la deuxième couche 300 qui forme la deuxième zone 310 peut être du type intrinsèque ou du type non intentionnellement dopé.

On entend par « du type intrinsèque » que la portion de la deuxième couche 300, qui forme la majeure partie 320 de la deuxième zone 310, comporte une concentration en porteurs d'un premier type qui est sensiblement identique à la concentration en porteurs d'un deuxième type qui est opposé au premier type de porteurs.

La deuxième couche 300, au moins pour sa portion qui forme la deuxième zone 310, présente une largeur de bande interdite qui est adaptée afin d'optimiser lors du fonctionnement de la structure 1 le taux de multiplication des porteurs lors de leur transit dans ladite deuxième couche 310.

De même, l'épaisseur de la deuxième couche 300 est suffisamment importante pour que la structure 1 présente un taux de multiplication des porteurs générés dans la première couche 200 adapté pour fournir un signal mesurable.

Selon une possibilité de l'invention la deuxième couche 300 comporte une largeur de bande interdite inférieure à celle de la première zone 210 semiconductrice. Selon cette possibilité, la largeur de bande interdite de la deuxième couche 300 est adaptée pour favoriser l'absorption du rayonnement électromagnétique dans une deuxième gamme de longueurs d'onde dont l'énergie est inférieure à la gamme de longueurs d'onde donnée. Avec une telle possibilité, la structure 1 permet, en fonctionnement, la détection et la mesure d'un rayonnement dont la longueur d'onde est comprise dans la deuxième gamme de longueurs d'onde en complément de la mesure de rayonnements électromagnétiques à la longueur d'onde donnée.

Dans l'application particulière, la portion de la deuxième couche 300 qui forme la majeure partie 320 de la deuxième zone 310 est réalisée en un tellurure de mercure-cadmium du type CdₓHg₁₋ₓTe dont la proportion en cadmium x est comprise entre 0,42 et 0,2 et préférentiellement comprise entre 0,4 et 0,29 pour fournir une deuxième gamme de longueurs d'onde comprenant le rayonnement thermique. Dans cette même application particulière la deuxième couche 300, au moins sur sa portion formant la majeure partie 320 de la deuxième zone 310 est d'un type de conductivité opposé à celui de la première zone 210 et est donc un type de conductivité pour lequel les porteurs majoritaires sont des électrons. La concentration en porteurs majoritaires de la portion de la deuxième couche 300 formant la deuxième zone 310 est comprise entre 10¹⁴ et 10¹⁵ cm⁻³.

On entend ci-dessus par rayonnement thermique la gamme de longueurs d'onde des infrarouges lointains comprise entre 3 et 10 µm.

Selon l'application particulière, l'épaisseur de la deuxième couche 300 est comprise entre 0,5 et 2 µm.

La cavité 520 est aménagée dans la deuxième couche 300 de manière à délimiter latéralement la deuxième zone 310. Ainsi, la cavité 520 traverse la deuxième couche 300 sur toute son épaisseur. La cavité 520 forme un moyen de délimitation latérale de la deuxième zone 310 adapté pour délimiter latéralement la deuxième zone 520. La cavité 520 est au moins partiellement remplie par la couche de passivation 620.

La deuxième couche 300 comporte également la troisième zone 410 semiconductrice.

La troisième zone 410 est du deuxième type de conductivité qui est opposé au premier type de conductivité. La troisième zone 410 comporte une concentration en porteurs majoritaires au moins 10 fois, et préférentiellement 50 fois, plus importante que celle de la deuxième zone 310.

La largeur de bande interdite de la troisième zone 410 est sensiblement identique à celle de la deuxième couche 300 semiconductrice.

Dans l'application particulière, la troisième zone 410 présente le même type de conductivité que celui de la deuxième zone 310. La concentration en porteurs majoritaires est comprise entre 10¹⁶ et 10¹⁸ cm⁻³.

La deuxième couche 300 semiconductrice est en contact sur sa face qui est opposée à la première couche 200 avec la couche de passivation 620.

La couche de passivation 620 s'étend le long de la deuxième couche 300. La couche de passivation 620 est préférentiellement formée dans un matériau isolant, tel que par exemple l'oxyde de silicium.

La couche de passivation 620 présente une ouverture traversante en communication avec la partie de la couche d'adaptation 610 comportant la troisième zone 410.

Dans l'application particulière, la couche de passivation 620 est réalisée en sulfure de zinc ZnS.

Le contact électrique 710 est en contact avec la troisième zone 410 au travers de l'ouverture aménagée dans la couche de passivation 620.

Le contact électrique 710 est formé dans un matériau conducteur, généralement métallique, adapté pour former un contact ohmique avec la troisième zone 410 semiconductrice.

On peut enfin noter que la structure 1 comporte également, bien que cela ne soit pas illustré sur la figure 1, un deuxième moyen de polarisation, qui peut être un contact électrique traversant la couche de passivation 620 et la deuxième couche 300 pour être en contact électrique avec la première couche 200. La première couche 200 présentant généralement une concentration en porteurs majoritaires suffisante pour la rendre conductrice, la structure 1 étant une structure parmi une pluralité, le deuxième moyen peut être un deuxième contact électrique collectif adapté pour polariser plusieurs des structures.

Une telle structure 1, lorsqu'elle est une structure selon l'application particulière, peut être formée par un procédé de fabrication comportant les étapes consistant à :
- fournir un support 100 semiconducteur et la première couche 200 semiconductrice, la première couche comportant une première et une seconde face 201, 202, la première couche 200 étant formée en tellurure de mercure-cadmium du type CdₓHg₁₋ₓTe avec une proportion x en cadmium qui est diminuée en direction de la deuxième zone le long d'un axe sensiblement perpendiculaire à la première face longitudinale 201, la première couche 200 étant du premier type de conductivité avec une concentration en arsenic qui est variée alternativement entre la concentration forte et la concentration faible,
- former la deuxième couche 300 en contact avec la deuxième face 202 de la première couche 200, la deuxième couche 300 comportant une première et une seconde face 301, 302, et étant en contact avec la première couche 200 par sa première face 301,
- former la couche de passivation 620 sur la face de la deuxième couche 300 qui est opposée à la première couche 200,
- implanter sélectivement avec des éléments dopants la portion de la deuxième couche 300 qui est destinée à former la troisième zone 410 semiconductrice et former ainsi la troisième zone 410,
- former dans la couche de passivation 620 une ouverture traversante en communication avec la troisième zone 410,
- former le contact électrique 710 au travers de l'ouverture de la couche de passivation 620 et en contact électrique avec la troisième zone 410,
- former le deuxième moyen de polarisation adapté pour polariser la première zone 210 semiconductrice.

L'étape de fourniture du support et de la deuxième couche comprend les sous-étapes consistant à :
- fournir un support 100 comportant une surface longitudinale,
- déposer en contact avec la surface longitudinale du support 100 du tellurure de mercure-cadmium du type CdₓHg₁₋ₓTe en variant la proportion x de cadmium, et en y introduisant l'élément dopant qui est l'arsenic avec une concentration en arsenic qui est variée alternativement dans la direction sensiblement perpendiculaire à la surface longitudinale, qui représente une première face longitudinale 201, entre une concentration dite faible et une concentration dite forte.

Lors de cette dernière sous-étape la concentration x en cadmium est diminuée en direction de la deuxième zone 310 le long d'un axe sensiblement perpendiculaire à la première face longitudinale 201.

En fonctionnement, la structure 1 est fortement polarisée en inverse, c'est-à-dire que pour une première et une troisième zone 210, 410 présentant chacune un type de conduction dans lequel les porteurs majoritaires sont respectivement des trous et des électrons, la première zone 210 est fortement polarisée négativement vis-à-vis de la troisième zone 410. Ainsi, la jonction semiconductrice se trouvant à l'interface entre la première et la deuxième zone 210, 310 et la deuxième zone 310 présentant une faible concentration en porteurs majoritaires vis-à-vis de la première zone 210, la chute de potentiel se répartit principalement le long de la deuxième zone 310 semiconductrice.

Lorsqu'un photon d'un rayonnement électromagnétique dont la longueur d'onde est comprise dans la gamme de longueurs d'ondes donnée pénètre dans la première zone 210, son absorption génère dans la première zone 210 une paire électron-trou. L'électron et le trou ainsi générés sont séparés l'un de l'autre par le champ électrique généré par la variation de la proportion de cadmium le long de la première zone 210. L'électron, accéléré par le champ, transit vers la deuxième zone 310.

Dans la deuxième zone 310, en raison du matériau qui la compose et du champ électrique qui y règne, l'électron va produire un nombre multiple d'ionisations par impact et donc former un courant de multiples électrons qui est ensuite collecté par la troisième zone 410.

Ainsi, en raison du champ électrique qui règne dans la première zone, le temps de transit de l'électron dans la première zone 210 est réduit et entraine donc une réduction du temps de réponse vis-à-vis d'une structure 1 présentant une première zone selon l'art antérieur.

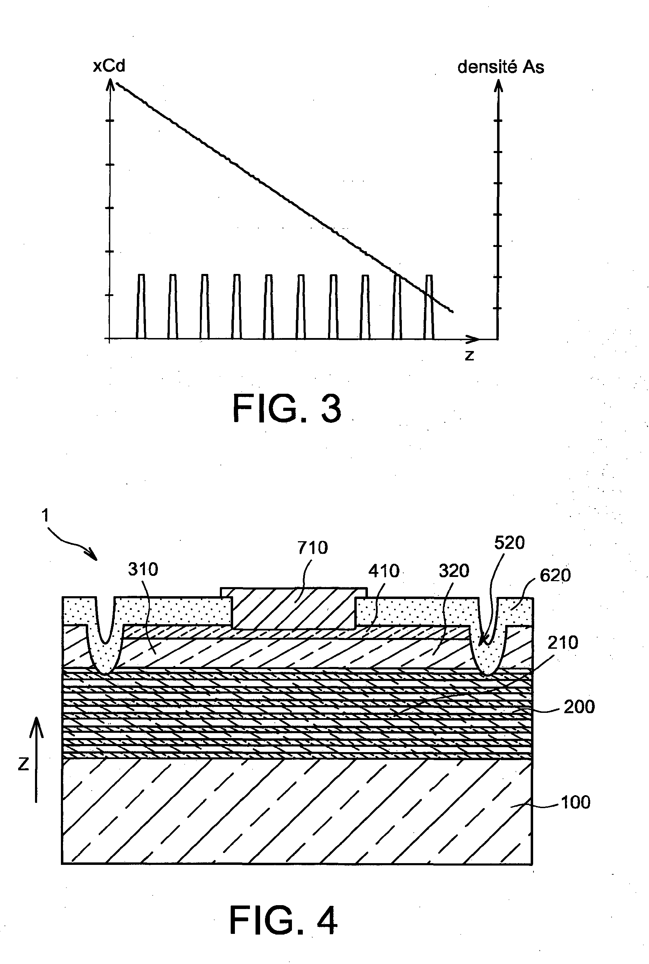

La figure 4 illustre une structure 1 selon un deuxième mode de réalisation de l'invention dans lequel la troisième zone 410 s'étend sur la totalité de la largeur de la deuxième zone 310. Une structure 1 selon ce deuxième mode de réalisation se différencie d'une structure 1 selon le premier mode de réalisation en ce que la troisième zone 410 s'étend sur la totalité de la largeur de la deuxième zone 310 et en ce que la troisième zone 410 fait interface entre la couche de passivation 620 et la deuxième zone 310.

La troisième zone 410 est aménagée dans une portion de la deuxième couche 300.

Un procédé de fabrication d'une structure 1 selon ce deuxième mode de réalisation se différencie d'un procédé selon le premier mode de réalisation en ce que lors de l'étape d'implantation d'une portion de la deuxième couche 300, l'implantation est réalisée sur la totalité de la largeur de la deuxième zone 310 sur une partie de la hauteur de la deuxième zone 310.

Une structure 1 selon ce deuxième mode de réalisation fonctionne selon un principe sensiblement identique à celui d'une structure 1 selon le premier mode de réalisation.

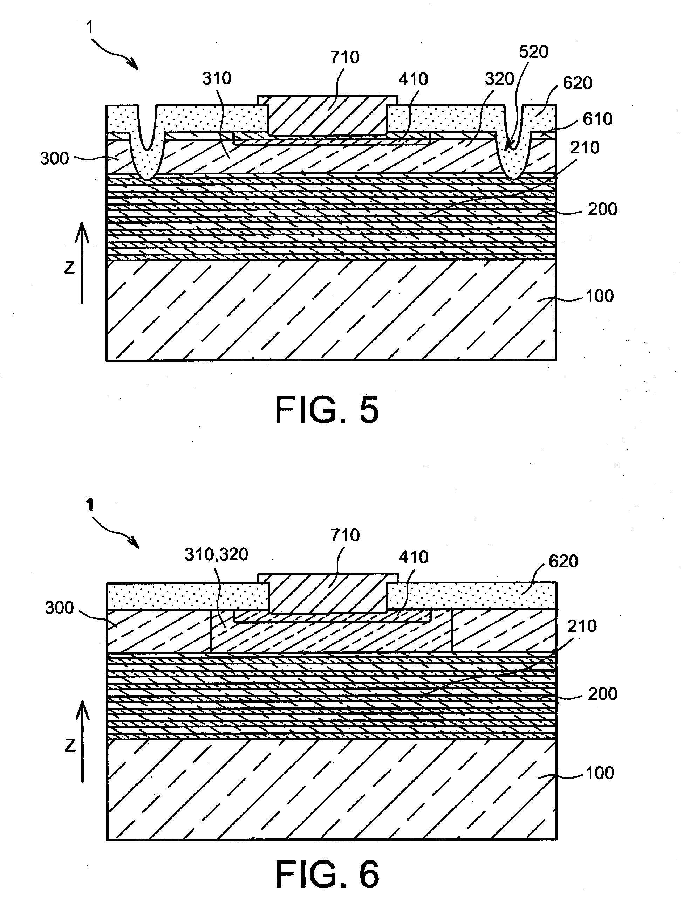

La figure 5 illustre une structure 1 selon un troisième mode de réalisation de l'invention dans lequel la structure 1 comporte une couche d'adaptation 610. Une structure 1 selon ce troisième mode de réalisation se différencie d'une structure 1 selon le premier mode de réalisation en ce que la deuxième zone 310 est aménagée à la fois dans la deuxième couche 300 et dans la couche d'adaptation 610, la première et la deuxième sous-partie étant des parties de la majeure partie de la deuxième zone 310 qui est comprise dans la deuxième couche 300.

Dans ce troisième mode de réalisation, la deuxième couche 300 semiconductrice comporte une seconde face 302 qui est opposée à la première face 301. La deuxième couche 300 est en contact par sa deuxième face 302 avec la couche d'adaptation 610.

La couche d'adaptation 610 est une troisième couche semiconductrice qui est adaptée pour former une bonne interface entre la deuxième couche 300 semiconductrice et la couche de passivation 620. A cet effet, la couche d'adaptation 610 présente une largeur de bande interdite intermédiaire entre celle de la majeure partie 320 de la deuxième zone 310 et la largeur de bande interdite de la couche de passivation 620.

La couche d'adaptation 610 est du deuxième type de conductivité. La couche d'adaptation 610 comporte, à l'exclusion de sa portion formant la troisième zone 410 semiconductrice, une concentration en porteurs majoritaires qui est du même ordre de grandeur que celle de la majeure partie 320 de la deuxième zone 310 et préférentiellement sensiblement égale à celle de la majeure partie 320 de la deuxième zone 310. Ainsi la couche d'adaptation 610 comporte une partie minoritaire 330 de la deuxième zone 310 semiconductrice par laquelle la deuxième zone 310 est en contact avec la couche de passivation 620.

Dans l'application particulière, la couche d'adaptation 610 est formée en un tellurure de mercure-cadmium du type CdₓHg₁₋ₓTe avec la proportion x en cadmium qui est comprise entre 0,7 et 0,4. Dans cette même application particulière, la couche d'adaptation 610 est du même type de conductivité que celui de la deuxième zone 310 et est donc un type de conductivité pour lequel les porteurs majoritaires sont des électrons. La concentration en porteurs majoritaires dans la couche d'adaptation 610 est sensiblement égale à celle de la deuxième zone 310 et est donc comprise entre 10¹⁴ et 10¹⁵ cm⁻³.

La couche d'adaptation 610 comporte une part de la troisième zone semiconductrice 410. La troisième zone 410 est partiellement formée dans la deuxième couche 300, en contact avec la deuxième zone 310, le reste de la troisième zone 410 étant compris dans la couche d'adaptation 610.

La cavité 520, selon ce troisième mode de réalisation, traverse également la couche d'adaptation 610.

La figure 6 illustre une structure selon un quatrième mode de réalisation de l'invention dans lequel la structure ne comporte pas de cavité, la deuxième zone étant délimitée par une zone dont la conductivité est modifiée. Une structure selon ce quatrième mode de réalisation se différencie d'une structure selon le premier mode de réalisation en ce que la deuxième zone est délimitée par une zone dont la conductivité est du deuxième type de conductivité, le reste de la deuxième couche semiconductrice étant du premier type de conductivité.

Ainsi dans ce mode de réalisation pour l'application particulière de l'invention, la délimitation latérale peut être obtenue en générant une source de dopage du premier type de conductivité dans la première et la deuxième couche 200, 300. Ceci peut notamment être réalisé par un dopage complémentaire fourni par une génération de lacunes de mercure (VHg) qui sont donc associées avec des niveaux d'accepteurs, c'est-à-dire fournissant des trous. Une conductivité fournie par des lacunes de mercures permet, lors de la formation de la zone de contact 410 par implantation d'éléments dopants, de former une zone de faible dopage, au niveau du dopage résiduel qui s'étend à partir de la zone de collecte 310. Dans ce dernier mode de réalisation de l'invention, c'est la zone 310 ainsi formée qui va constituer la zone de multiplication, qui est délimitée latéralement par les lacunes de mercure non comblées et verticalement par la deuxième couche 200.

## Revendications

1. Structure (1) semiconductrice de type photodiode à avalanche destinée à recevoir un rayonnement électromagnétique dans une gamme de longueurs d'onde donnée et comportant :
- une première zone (210) semiconductrice, dite d'absorption, d'un premier type de conductivité présentant une première face longitudinale (201) destinée à recevoir le rayonnement électromagnétique et une seconde face opposée à la première face (201), ladite première zone (210) étant réalisée en tellurure de mercure-cadmium du type CdₓHg₁₋ₓTe avec une proportion x de cadmium qui est variée,
- au moins une deuxième zone (310) semiconductrice, dite de multiplication, en contact sur une première face avec la seconde face de la première zone (210), la deuxième zone (310) présentant une concentration en porteurs majoritaires inférieure à celle de la première zone (210), ladite deuxième zone (310) étant adaptée pour fournir une multiplication de porteurs par ionisation par impact,
- une troisième zone (410) semiconductrice, dite de collecte, en contact avec la deuxième zone (310), ladite troisième zone (410) étant d'un deuxième type de conductivité opposé au premier type de conductivité et présentant une concentration en porteurs majoritaires supérieure à celle de la deuxième zone (310),
la structure étant **caractérisée en ce que** la première zone (210) comporte un élément dopant fournissant au moins un porteur correspondant au premier type de conductivité dont la concentration est variée alternativement dans une direction sensiblement perpendiculaire à la première face longitudinale (201) entre une concentration dite faible et une concentration dite forte.

2. Structure (1) selon la revendication 1, dans laquelle la première zone (210) comporte une proportion x en cadmium qui est diminuée en direction de la deuxième zone (310) le long d'un axe sensiblement perpendiculaire à la première face longitudinale (201).

3. Structure (1) selon la revendication 1 ou 2, dans laquelle la concentration faible en l'élément dopant est sensiblement nulle.

4. Structure (1) selon l'une quelconque des revendications précédentes, dans laquelle l'alternance entre la concentration faible et la concentration forte dans la première zone (210) est sensiblement périodique.

5. Structure (1) selon la revendication précédente, dans laquelle chaque période comporte une première partie correspondant à la concentration forte et une deuxième partie correspondant à la concentration faible, le rapport dimensionnel entre la première partie et la deuxième partie selon la direction perpendiculaire à la première face longitudinale (201) étant au maximum de 10.

6. Structure (1) selon l'une quelconque des revendications précédentes, dans laquelle la première zone (210) est en contact avec la deuxième zone (310) par une région sensiblement dépourvue d'élément dopant.

7. Structure (1) selon l'une quelconque des revendications précédentes, dans laquelle l'élément dopant est l'arsenic.

8. Procédé de fabrication d'une structure (1) selon la revendication 1 comprenant les étapes consistant à :
- fournir une première zone (210) semiconductrice d'un premier type de conductivité présentant une première face longitudinale (201) destinée à recevoir le rayonnement électromagnétique et une seconde face opposée à la première face, ladite première zone (210) étant en un tellurure de mercure-cadmium de type CdₓHg₁₋ₓTe avec une proportion x de cadmium qui est variée, la première zone (210) comportant un élément dopant dont la concentration est variée alternativement dans la direction perpendiculaire à la première face longitudinale (201) entre une concentration dite faible et une concentration dite forte,
- former une deuxième zone (310) semiconductrice en contact avec la seconde face de la première zone (210), la deuxième zone (310) présentant une concentration en porteurs majoritaires inférieure à celle de la première zone (210),
- former une troisième zone (410) semiconductrice en contact avec la deuxième zone (310), ladite troisième zone (410) étant d'un deuxième type de conductivité opposé au premier type de conductivité et présentant une concentration en porteurs majoritaires supérieure à celle de la deuxième zone (310).

9. Procédé de fabrication selon la revendication précédente, dans lequel l'étape de fourniture de la première zone (210) comprend les sous-étapes consistant à :
- fournir un support (100) comportant une surface longitudinale,
- déposer en contact avec la surface longitudinale du support (100) du tellurure de mercure-cadmium du type CdₓHg₁₋ₓTe en variant la proportion x de cadmium, et en y introduisant l'élément dopant avec une concentration qui est variée alternativement dans la direction sensiblement perpendiculaire à la surface longitudinale entre une concentration dite faible et une concentration dite forte.

10. Procédé selon la revendication précédente, dans lequel lors de la sous étape consistant à déposer en contact avec la surface du support (100) du tellurure de mercure-cadmium, la concentration en l'élément dopant est variée sensiblement périodiquement.

11. Procédé selon l'une quelconque des revendications 8 à 10, dans lequel l'élément dopant fournissant au moins un porteur majoritaire est l'arsenic.

## Patentansprüche

1. Halbleiterstruktur (1) vom Typ Lawinen-Fotodiode, die dazu bestimmt ist, eine elektromagnetische Strahlung in einem gegebenen Wellenlängenbereich zu empfangen und enthält:
- einen ersten Halbleiterbereich (210), Absorptionsbereich genannt, mit einem ersten Leitungstyp, der eine erste Längsseite (201) aufweist, die dazu bestimmt ist, die elektromagnetische Strahlung zu empfangen, sowie eine der ersten Seite (201) entgegengesetzte zweite Seite, wobei der erste Bereich (210) aus Quecksilber-Cadmium-Tellurid vom Typ CdₓHg₁₋ₓTe mit einem sich ändernden Cadmium-Anteil x ausgeführt ist,
- zumindest einen zweiten Halbleiterbereich (310), Multiplikationsbereich genannt, der auf einer ersten Seite in Kontakt mit der zweiten Seite des ersten Bereichs (210) ist, wobei der zweite Bereich (310) eine Konzentration an Majoritätsträgern aufweist, die niedriger als die des ersten Bereichs (210) ist, wobei der zweite Bereich (310) dazu geeignet ist, eine Multiplikation von Trägern durch Stoßionisation zu erbringen,
- einen dritten Halbleiterbereich (410), Sammelbereich genannt, der mit dem zweiten Bereich (310) in Kontakt steht, wobei der dritte Bereich (410) von einem zweiten Leitungstyp ist, welcher dem ersten Leitungstyp entgegengesetzt ist und eine Konzentration an Majoritätsträgern aufweist, die höher als die des zweiten Bereichs (310) ist,
wobei die Struktur **dadurch gekennzeichnet ist, dass** der erste Bereich (210) ein Dotierungselement aufweist, das zumindest einen dem ersten Leitungstyp entsprechenden Träger bereitstellt, dessen Konzentration sich abwechselnd in einer Richtung im Wesentlichen senkrecht zur ersten Längsseite (201) zwischen einer sogenannten schwachen Konzentration und einer sogenannten starken Konzentration ändert.

2. Struktur (1) nach Anspruch 1, wobei der erste Bereich (210) einen Cadmium-Anteil x aufweist, der in Richtung des zweiten Bereichs (310) entlang einer Achse im Wesentlichen senkrecht zur ersten Längsseite (201) abnimmt.

3. Struktur (1) nach Anspruch 1 oder 2, wobei die schwache Konzentration des Dotierungselements im Wesentlichen null beträgt.

4. Struktur (1) nach einem der vorangehenden Ansprüche, wobei die Wechselfolge zwischen der schwachen Konzentration und der starken Konzentration in dem ersten Bereich (210) im Wesentlichen periodisch ist.

5. Struktur (1) nach dem vorangehenden Anspruch, wobei jede Periode einen ersten Teil aufweist, welcher der starken Konzentration entspricht, sowie einen zweiten Teil, welcher der schwachen Konzentration entspricht, wobei das maßliche Verhältnis zwischen dem ersten Teil und dem zweiten Teil in der zur ersten Längsseite (201) senkrechten Richtung höchstens 10 beträgt.

6. Struktur (1) nach einem der vorangehenden Ansprüche, wobei der erste Bereich (210) über einen im Wesentlichen dotierungselementfreien Bereich mit dem zweiten Bereich (310) in Kontakt steht.

7. Struktur (1) nach einem der vorangehenden Ansprüche, wobei das Dotierungselement Arsen ist.

8. Verfahren zum Herstellen einer Struktur (1) nach Anspruch 1, umfassend die nachfolgenden Schritte:
- Bereitstellen eines ersten Halbleiterbereichs (210) mit einem ersten Leitungstyp, der eine erste Längsseite (201) aufweist, die dazu bestimmt ist, die elektromagnetische Strahlung zu empfangen, sowie eine der ersten Seite entgegengesetzte zweite Seite, wobei der erste Bereich (210) aus Quecksilber-Cadmium-Tellurid vom Typ CdₓHg₁₋ₓTe mit einem sich ändernden Cadmium-Anteil x besteht, wobei der erste Bereich (210) ein Dotierungselement aufweist, dessen Konzentration sich abwechselnd in einer Richtung im Wesentlichen senkrecht zur ersten Längsseite (201) zwischen einer sogenannten schwachen Konzentration und einer sogenannten starken Konzentration ändert,
- Bilden eines zweiten Halbleiterbereichs (310), der mit der zweiten Seite des ersten Bereichs (210) in Kontakt steht, wobei der zweite Bereich (310) eine Konzentration an Majoritätsträgern aufweist, die niedriger als die des ersten Bereichs (210) ist,
- Bilden eines dritten Halbleiterbereichs (410), der mit dem zweiten Bereich (310) in Kontakt steht, wobei der dritte Bereich (410) von einem zweiten Leitungstyp ist, welcher dem ersten Leitungstyp entgegengesetzt ist und eine Konzentration an Majoritätsträgern aufweist, die höher als die des zweiten Bereichs (310) ist.

9. Herstellungsverfahren nach dem vorangehenden Anspruch, wobei der Schritt des Bereitstellens des ersten Bereichs (210) die nachfolgenden Unterschritte umfasst:
- Bereitstellen eines Trägers (100) mit einer Längsfläche,
- Aufbringen von Quecksilber-Cadmium-Tellurid vom Typ CdₓHg₁₋ₓTe in Kontakt mit der Längsfläche des Trägers (100), indem der Cadmium-Anteil x verändert wird und indem das Dotierungselement mit einer Konzentration eingeführt wird, die sich abwechselnd in der Richtung im Wesentlichen senkrecht zur Längsfläche zwischen einer sogenannten schwachen Konzentration und einer sogenannten starken Konzentration ändert.

10. Verfahren nach dem vorangehenden Anspruch, wobei bei dem Unterschritt des Aufbringens von Quecksilber-Cadmium-Tellurid in Kontakt mit der Fläche des Trägers (100) die Konzentration an Dotierungselement sich im Wesentlichen periodisch ändert.

11. Verfahren nach einem der Ansprüche 8 bis 10, wobei das zumindest einen Majoritätsträger bereitstellende Dotierungselement Arsen ist.

## Claims

1. Avalanche photodiode-type semiconductor structure (1) intended to receive electromagnetic radiation in a given wavelength and comprising:
- a first semiconductor zone (210), called an absorption zone, with a first type of conductivity having a first longitudinal face (201) intended to receive the electromagnetic radiation and a second face opposite the first face (201), said first zone (210) being made of mercury-cadmium telluride of the CdₓHg₁₋ₓTe type with a cadmium proportion x that is varied,
- at least one second semiconductor zone (310), called a multiplication zone, in contact on a first longitudinal face with the second face of the first zone (210), the second zone (310) having a majority carrier concentration lower than that of the first zone (210), said second zone (310) being adapted so as to provide a multiplication of carriers by impact ionization,
- a third semiconductor zone (410), called a collection zone, in contact with the second zone (310), said third zone (410) having a second type of conductivity opposite the first type of conductivity and having a majority carrier concentration higher than that of the second semiconductor zone (310),
the structure being **characterized in that** the first zone (210) comprises a doping element providing at least one majority carrier corresponding to the first type of conductivity, of which the concentration is varied alternately in a direction substantially perpendicular to the first longitudinal face (201) between a so-called low concentration and a so-called high concentration.

2. Structure (1) according to claim 1, wherein the first zone (210) comprises a cadmium portion x that is reduced in the direction of the second zone (310) along an axis substantially perpendicular to the first longitudinal face (201).

3. Structure (1) according to claim 1 or 2, wherein the low concentration of doping element can be substantially zero.

4. Structure (1) according to any one of the previous claims, wherein the alternation between the low concentration and the high concentration in the first zone (210) is substantially periodic.

5. Structure (1) according to the previous claim, wherein each period comprises a first part corresponding to the high concentration and a second part corresponding to the low concentration, the dimensional ratio between the first part and the second part in the direction perpendicular to the first longitudinal face (201) being a maximum of 10.

6. Structure (1) according to any one of the previous claims, wherein the first zone (210) is in contact with the second zone (310) by a region substantially free of doping element.

7. Structure (1) according to any one of the previous claims, wherein the doping element is arsenic.

8. Process for producing a structure (1) according to claim 1 including the steps consisting of:
- providing a first semiconductor zone (210) with a first type of conductivity having a first longitudinal face (201) intended to receive the electromagnetic radiation and a second face opposite the first face, said first zone (210) being made of mercury-cadmium telluride of the CdₓHg₁₋ₓTe type with a cadmium proportion x that is varied, the first zone (210) comprising a doping element of which the concentration is varied alternately in the direction perpendicular to the first longitudinal face (201) between a so-called low concentration and a so-called high concentration,
- forming a second semiconductor zone (310) in contact with the second face of the first zone (210), the second zone (310) having a majority carrier concentration lower than that of the first zone (210),
- forming a third semiconductor zone (410) in contact with the second zone (310), said third zone (410) having a second type of conductivity opposite the first type of conductivity and having a majority carrier concentration greater than that of the second zone (310).

9. Production process according to the previous claim, wherein the step of providing the first zone (210) includes sub-steps consisting of:
- providing a support (100) comprising a longitudinal surface,
- depositing, on the longitudinal surface of the support (100), mercury-cadmium telluride of the CdₓHg₁₋ₓTe type by varying the cadmium proportion x and introducing the doping element into it with a concentration that is varied alternately in the direction substantially perpendicular to the longitudinal surface between a so-called low concentration and a so-called high concentration.

10. Process according to the previous claim, wherein, during the sub-step consisting of depositing the mercury-cadmium telluride in contact with the support (100), the doping element concentration is varied substantially periodically.

11. Process according to any one of claims 8 to 10, wherein the doping element providing at least one majority carrier can be arsenic.
